# EUROPÄISCHE PATENTSCHRIFT

(11) **EP 2 198 465 B1**
(45) Veröffentlichungstag und Bekanntmachung des Hinweises auf die Patenterteilung: **15.05.2019**
(21) Anmeldenummer: 08801322.2
(22) Anmeldetag: 11.09.2008
(51) Int. Cl.: H01L 33/50, F21K 9/64, F21V 9/30, H01L 33/58, H01L 33/60, F21Y 115/10

(54) **HALBLEITERLICHTQUELLE MIT EINER PRIMÄRSTRAHLUNGSQUELLE UND EINEM LUMINESZENZKONVERSIONSELEMENT**
SEMICONDUCTOR LIGHT SOURCE HAVING A PRIMARY RADIATION SOURCE AND A LUMINESCENCE CONVERSION ELEMENT
SOURCE DE LUMIÈRE SEMI-CONDUCTRICE COMPORTANT UNE SOURCE DE RAYONNEMENT PRIMAIRE ET UN ÉLÉMENT CONVERTISSEUR DE LUMINESCENCE

(30) Priorität: 28.09.2007 DE 102007046608; 03.03.2008 DE 102008012316
(43) Veröffentlichungstag der Anmeldung: 23.06.2010
(73) Patentinhaber: OSRAM Opto Semiconductors GmbH, 93055 Regensburg (DE)
(72) Erfinder: OTT, Hubert, 93077 Bad Abbach (DE); LELL, Alfred, 93142 Maxhütte - Haidhof (DE); TAUTZ, Sönke, 93105 Tegernheim (DE); STRAUSS, Uwe, 93077 Bad Abbach (DE); BAUMANN, Frank, 93055 Regensburg (DE); PETERSEN, Kirstin, 79104 Freiburg (DE)
(74) Vertreter: Epping - Hermann - Fischer
(86) Internationale Anmeldenummer: PCT/DE2008/001529
(87) Internationale Veröffentlichungsnummer: WO 2009/039827

(56) Entgegenhaltungen:
- EP-A- 1 734 302
- WO-A-99/52341
- JP-A- 2005 294 185
- JP-A- 2006 179 658
- JP-A- 2007 207 615
- US-A1- 2006 203 468
- US-A1- 2006 291 246

## Beschreibung

Diese Patentanmeldung beansprucht die Priorität der deutschen Patentanmeldungen 102007046608.2 und 102008012316. 1.

Die vorliegende Anmeldung betrifft eine Halbleiterlichtquelle mit einer Primärstrahlungsquelle und einem Lumineszenzkonversionselement.

Die Druckschrift WO 99/52341 betrifft eine optische Kältemaschine.

Die Druckschriften US 2006/0291246 A1 und EP 1 734 302 A betreffen Licht emittierende Vorrichtungen.

Eine Halbleiterlichtquelle mit einer Primärstrahlungsquelle und einem Lumineszenzkonversionselement ist beispielsweise aus der Druckschrift US 6,066,861 bekannt. Derartige Halbleiterlichtquellen weisen oft eine nicht zufrieden stellende Abfuhr von Verlustwärme aus dem Lumineszenzkonversionselement auf. Bei solchen Halbleiterlichtquellen führt eine Bestrahlung des Lumineszenzkonversionselements durch die Primärstrahlungsquelle mit einer hohen Energiedichte daher in der Regel zu einer relativ starken Temperaturerhöhung des Lumineszenzkonversionselements, wodurch die Effizienz der Wellenlängenkonversion des Lumineszenzkonversionselements beeinträchtigt ist.

In der Druckschrift EP 1 734 302 A1 ist eine Halbleiterlichtquelle offenbart, bei der ein Lumineszenzkonversionselement mit einem Wärmeleitelement versehen ist.

Es ist eine Aufgabe der vorliegenden Anmeldung, eine Halbleiterlichtquelle mit Primärstrahlungsquelle und Lumineszenzkonversionsmodul anzugeben, bei der die Wellenlängenkonversion durch das Lumineszenzkonversionselement - insbesondere bei hohen Energiedichten der von der Primärstrahlungsquelle emittierten Primärstrahlung - besonders effizient ist.

Diese Aufgabe wird durch eine Halbleiterlichtquelle gemäß Patentanspruch 1 gelöst. Vorteilhafte Ausgestaltungen und Weiterbildungen der Halbleiterlichtquelle sind in den abhängigen Ansprüchen angegeben.

Es wird eine Halbleiterlichtquelle angegeben, die eine Primärstrahlungsquelle aufweist, welche im Betrieb der Halbleiterlichtquelle elektromagnetische Primärstrahlung emittiert. Insbesondere enthält die Primärstrahlungsquelle einen zur Emission der Primärstrahlung vorgesehenen optoelektronischen Halbleiterchip. Bei einer Weiterbildung ist der optoelektronische Halbleiterchip in einem optoelektronischen Halbleiterbauelement enthalten. Zum Beispiel ist er in einem Gehäuse des Halbleiterbauelements angeordnet. Bei dem optoelektronischen Halbleiterchip oder Halbleiterbauelement handelt es sich bei einer zweckmäßigen Ausgestaltung um eine Leuchtdiode oder um eine Laserdiode. Bei einer Ausgestaltung weist die Primärstrahlungsquelle eine Leuchtdiode oder Laserdiode auf, die im Betrieb Primärstrahlung im blauen und/oder im ultravioletten Spektralbereich emittiert. Beispielsweise weist sie eine UV-Leuchtdiode auf.

Die Halbleiterlichtquelle weist weiter ein Lumineszenzkonversionsmodul auf, in welches zumindest ein Teil der von der Primärstrahlungsquelle emittierte Primärstrahlung eingekoppelt wird. Vorzugsweise wird ein Großteil, insbesondere praktisch die gesamte von der Primärstrahlungsquelle emittierte Primärstrahlung in das Lumineszenzkonversionsmodul eingekoppelt.

Das Lumineszenzkonversionsmodul enthält ein Lumineszenzkonversionselement, welches mittels mindestens eines Leuchtstoffs, zum Beispiel mittels eines anorganischen Leuchtstoffs, Primärstrahlung zu elektromagnetischer Sekundärstrahlung wellenlängenkonvertiert. Insbesondere absorbiert das Lumineszenzkonversionselement Primärstrahlung und wird dadurch - etwa mittels Fluoreszenz oder Phosphoreszenz - zur Emission von Sekundärstrahlung angeregt.

Beispielsweise enthält die Primärstrahlung elektromagnetische Strahlung eines ersten Wellenlängenbereichs und die Sekundärstrahlung enthält elektromagnetische Strahlung eines zweiten Wellenlängenbereichs, der von dem ersten Wellenlängenbereich verschieden ist. Anders ausgedrückt überlappen der erste und der zweite Wellenlängenbereich nicht oder nur teilweise.

Das Lumineszenzkonversionsmodul ist von der Primärstrahlungsquelle beabstandet und an einem Kühlkörper angeordnet. Zweckmäßigerweise ist das Lumineszenzkonversionselement mit dem Kühlkörper thermisch leitend verbunden. Der Kühlkörper stellt bei einer Ausgestaltung einen Träger für das Lumineszenzkonversionsmodul dar.

Mit Vorteil bildet der Kühlkörper eine Wärmesenke für die bei der Konversion von Primärstrahlung zu Sekundärstrahlung erzeugte Verlustwärme. Beispielsweise handelt es sich bei dem Kühlkörper um einen metallischen Kühlkörper, an dem das Lumineszenzkonversionsmodul befestigt oder ausgebildet ist. Zum Beispiel weist der Kühlkörper eine Metallplatte auf.

Vorteilhafterweise ist aufgrund der Anordnung des Lumineszenzkonversionsmoduls an dem Kühlkörper in einem Abstand von der Primärstrahlungsquelle die Temperaturerhöhung des in dem Lumineszenzkonversionselement enthaltenen Leuchtstoffs bei Bestrahlung mit der Primärstrahlung besonders niedrig. Eine Erhöhung der Leuchtstofftemperatur hat in der Regel eine Verringerung der Effizienz zur Folge, mit welcher der Leuchtstoff Primärstrahlung zu Sekundärstrahlung wellenlängenkonvertiert. Die Halbleiterlichtquelle weist daher mit Vorteil eine besonders hohe Effizienz auf.

Bei einer Weiterbildung ist der Kühlkörper mit Vorsprüngen versehen, insbesondere an einer von dem Lumineszenzkonversionsmodul abgewandten Seite. Bei einer anderen Weiterbildung weist der Kühlkörper eine aktive Kühlvorrichtung auf. Beispielsweise ist der Kühlkörper ein Mikrokanalkühler und/oder er weist ein Peltier-Element auf. Auf diese Weise ist die Wärmeabfuhr von dem Lumineszenzkonversionselement mit Vorteil weiter verbessert.

Bei einer Ausgestaltung der Halbleiterlichtquelle ist die Primärstrahlungsquelle mit einem separaten Kühlkörper versehen. Auf diese Weise ist die Kühlung des Lumineszenzkonversionsmoduls unabhängig von der Kühlung der Primärstrahlungsquelle.

Bei einer anderen Ausgestaltung sind die Primärstrahlungsquelle und das Lumineszenzkonversionsmodul an dem gleichen Kühlkörper angeordnet, insbesondere also mechanisch an dem Kühlkörper befestigt und wärmeleitend mit diesem verbunden. Mittels eines gemeinsamen Kühlkörpers für die Primärstrahlungsquelle und das Lumineszenzkonversionsmodul wird vorteilhafterweise eine besonders kompakte Bauform der Halbleiterlichtquelle erzielt.

Erfindungsgemäß weist das Lumineszenzkonversionsmodul eine Reflektorschicht auf, die beispielsweise durch das Lumineszenzkonversionselement tretende, von diesem nicht absorbierte Primärstrahlung in das Lumineszenzkonversionselement zurückreflektiert. So wird vorteilhafterweise ein besonders großer Anteil der Primärstrahlung in dem Lumineszenzkonversionsmodul in Sekundärstrahlung wellenlängenkonvertiert.

Zusätzlich ist die Reflektorschicht dazu vorgesehen, Sekundärstrahlung in Richtung einer Lichtauskoppelfläche des Lumineszenzkonversionsmoduls zu reflektieren. Auf diese Weise wird mit Vorteil eine besonders hohe Leuchtdichte erzielt. Das Lumineszenzkonversionsmodul hat auf diese Weise eine besonders hohe Effizienz.

Erfindungsgemäß ist die Reflektorschicht auf eine dem Kühlkörper zugewandte Fläche des Lumineszenzkonversionselements oder auf eine dem Lumineszenzkonversionselement zugewandte Fläche des Kühlkörpers aufgebracht. Die Reflektorschicht hat vorzugweise eine Schichtdicke von kleiner oder gleich 1 µm, vorzugsweise von kleiner oder gleich 500 nm, besonders bevorzugt von kleiner oder gleich 100 nm. Mittels einer solchen Reflektorschicht wird mit Vorteil eine gut thermisch leitende Verbindung zwischen dem Lumineszenzkonversionselement und dem Kühlkörper erzielt.

Die Reflektorschicht enthält zum Beispiel mindestens eine metallische Schicht und/oder mindestens eine dielektrische Schicht. Beispielsweise enthält sie eine Schichtenfolge aus mindestens zwei solcher Schichten, also insbesondere eine Schichtenfolge mit einer metallischen und einer dielektrischen Schicht. Bei einer Ausgestaltung enthält die Reflektorschicht eine auf das Lumineszenzkonversionselement als Planarisierungsschicht aufgebrachte dielektrische Schicht und eine auf die dielektrische Schicht aufgebrachte, spiegelnde metallische Schicht.

Bei einer weiteren Ausgestaltung, bei der das Lumineszenzkonversionselement mit der Reflektorschicht versehen ist, ist das Lumineszenzkonversionselement mittels einer Lotschicht an dem Kühlkörper befestigt. Beispielsweise ist die Reflektorschicht mit dem Kühlkörper verlötet. So wird eine besonders effiziente Wärmeabfuhr von dem Lumineszenzkonversionselement erzielt.

Bei einer Weiterbildung der Halbleiterlichtquelle wird in das Lumineszenzkonversionsmodul eingekoppelte Primärstrahlung an der Reflektorschicht mehrfach reflektiert. Mit Vorteil wird auf diese Weise in dem Lumineszenzkonversionselement ein besonders hoher Anteil der Primärstrahlung absorbiert. Insbesondere wird auf diese Weise die Primärstrahlung auch auf einen besonders großen Bereich des Lumineszenzkonversionselements verteilt. Die Leuchtdichteverteilung der von dem Lumineszenzkonversionsmodul durch seine Lichtauskoppelfläche emittierten Sekundärstrahlung ist daher vorteilhafterweise besonders homogen.

Der Leuchtstoff des Lumineszenzkonversionselements, bei dem es sich auch um eine Mischung von mehreren Leuchtstoffen handeln kann, ist bei einer Ausgestaltung in Form eines Pulvers von Leuchtstoffpartikeln in dem Lumineszenzkonversionselement enthalten. Beispielsweise ist der Leuchtstoff elektrophoretisch auf der Reflektorfläche abgeschieden. Alternativ kann er auch mittels eines Druckverfahrens, beispielsweise eines Tintenstrahl-, Sieb- oder Tampondruckverfahrens abgeschieden sein. Auf diese Weise ist das Lumineszenzkonversionselement vorteilhafterweise einfach herstellbar. Bei einer Weiterbildung ist auf das Lumineszenzkonversionselement, das Leuchtstoff in Form eines Pulvers enthält, eine Fixierungsschicht, zum Beispiel eine Siliziumoxid-Schicht, aufgebracht, welche das Lumineszenzkonversionselement vorteilhafterweise vor mechanischer Beschädigung schützt.

Bei einer anderen Ausgestaltung enthält das Lumineszenzkonversionselement den Leuchtstoff in Form eines Einkristalls oder in Form eines polykristallinen, keramischen Materials. Der Leuchtstoff für ein Lumineszenzkonversionselement, das ein keramisches Material enthält, wird beispielsweise bei der Herstellung des Lumineszenzkonversionselement in die gewünschte Form gebracht, etwa mittels eines Press-Vorgangs, und anschließend durch Sintern in eine Keramik umgewandelt.

Lumineszenzkonversionselemente mit einem Leuchtstoff, der in einem Matrixmaterial wie einem Silikon- oder Epoxidharz dispergiert ist, haben oft eine unzureichende Wärmeleitfähigkeit und sind für die vorliegende Halbleiterlichtquelle daher nur bedingt geeignet. Die Wärmeleitfähigkeit des Lumineszenzkonversionselements ist mittels des pulverförmigen Leuchtstoffs, des Einkristalls und/oder des Leuchtstoffs in Form eines keramischen Materials besonders hoch, so dass bei diesen Ausgestaltungen eine besonders effiziente Abfuhr von Verlustwärme aus dem Lumineszenzkonversionselement erfolgt.

Leuchtstoffe in Form eines Einkristalls oder eines keramischen Materials haben eine besonders hohe Wärmeleitfähigkeit.

Bei einer Ausgestaltung hat das Lumineszenzkonversionselement im Wesentlichen die Form einer ebenen Schicht oder die Form einer, vorzugsweise planparallelen, Platte. Zum Beispiel weist die Oberfläche der Schicht beziehungsweise der Platte eine erste Hauptfläche auf, welche die Lichtauskoppelfläche darstellt. Sie weist insbesondere zudem eine zweite Hauptfläche auf, die der ersten Hauptfläche gegenüber liegt und vorzugsweise zur ersten Hauptfläche parallel verläuft. Zudem weist die Oberfläche der Schicht oder Platte mindestens eine Seitenfläche auf. Die Seitenfläche oder die Seitenflächen verbindet/verbinden insbesondere die erste und die zweite Hauptfläche.

Unter einer ebenen Schicht oder einer planparallelen Platte wird im vorliegenden Zusammenhang eine Schicht oder Platte verstanden, die - abgesehen von einer möglichen Aufrauung und/oder Strukturierung ihrer Oberfläche - gerade verläuft. Anders ausgedrückt ist die ebene Schicht oder planparallele Platte also frei von einer Krümmung oder einem Knick, sie verläuft insbesondere im Wesentlichen parallel zu einer Ebene. Mit anderen Worten hat die ebene Schicht oder die planparallele Platte eine Haupterstreckungsebene, zu der die erste und/oder die zweite Hauptfläche im Wesentlichen parallel ist. Die Oberfläche der Schicht oder Platte ist dabei, auch wenn sie nicht gezielt aufgeraut und/oder strukturiert ist, in der Regel nicht im mathematischen Sinn eben oder plan, vielmehr wird sie beispielsweise von einer Vielzahl von Partikel gebildet, so dass sich nur im Mittel ein - abgesehen von einer möglichen Aufrauung und/oder Strukturierung - im Wesentlichen ebener oder planparalleler Verlauf der ersten und zweiten Hauptfläche ergibt.

Bei einer Ausgestaltung bedeckt die Reflektorfläche oder ein zweiter Teilbereich der Reflektorfläche die mindestens eine Seitenfläche stellenweise oder vollständig.

Bei einer anderen Weiterbildung ist die zweite Hauptfläche dem Kühlkörper zugewandt. Die zweite Hauptfläche ist beispielsweise zumindest stellenweise von der Reflektorfläche oder von dem ersten Teilbereich der Reflektorfläche bedeckt. Insbesondere ist die Reflektorfläche oder der erste Teilbereich der Reflektorfläche also zwischen der zweiten Hauptfläche des Lumineszenzkonversionselements und dem Kühlkörper angeordnet.

Bei einer Ausführungsform wird Primärstrahlung der Primärstrahlungsquelle durch die erste Hauptfläche in das Lumineszenzkonversionselement eingekoppelt. Die Lichtauskoppelfläche des Lumineszenzkonversionselements dient bei dieser Ausführungsform auch als Lichteinkoppelfläche für die Primärstrahlung.

Bei einer Weiterbildung dieser Ausführungsform weist die erste Hauptfläche eine Aufrauung und/oder eine Strukturierung, beispielsweise mit rillen-, noppen- und/oder pyramidenförmigen Vorsprüngen und/oder Einbuchtungen, auf. Beispielsweise ist so die Einkopplung für Primärstrahlung, die unter einem flachen Winkel auf die erste Hauptfläche des Lumineszenzkonversionselements trifft, verbessert.

Bei einer Ausgestaltung ist die Halbleiterlichtquelle dazu vorgesehen, Mischstrahlung zu emittieren, welche von der Primärstrahlungsquelle emittierte Primärstrahlung und von dem Lumineszenzkonversionsmodul emittierte Sekundärstrahlung enthält oder daraus besteht. Mittels der aufgerauten und/oder strukturierten ersten Hauptfläche wird bei dieser Weiterbildung eine gute Durchmischung der von der Halbleiterlichtquelle emittierten Primärstrahlung und Sekundärstrahlung erzielt.

Bei einer anderen Ausführungsform wird Primärstrahlung der Primärstrahlungsquelle durch die Seitenfläche oder mindestens eine der Seitenflächen in das Lumineszenzkonversionselement eingekoppelt. Insbesondere ist die Primärstrahlungsquelle bei dieser Ausführungsform seitlich von dem Lumineszenzkonversionsmodul angeordnet. Bei einer Weiterbildung ist die Seitenfläche beziehungsweise sind die Seitenflächen bis auf einen Einkoppelbereich, durch welchen die Primärstrahlung in das Lumineszenzkonversionselement eingekoppelt wird, vollständig von der Reflektorfläche bedeckt.

Bei dieser Ausführungsform ist die Gefahr einer Abschattung einer durch die Lichtauskoppelfläche emittierten elektromagnetischen Strahlung durch die Primärstrahlungsquelle und/oder durch ein optisches Element, mittels welchem die Primärstrahlung in das Lumineszenzkonversionselement eingekoppelt wird, besonders gering. Mehrfachreflektionen an der Reflektorfläche werden bei dieser Ausführungsform besonders einfach erzielt.

Der Einkoppelbereich ist beispielsweise in Draufsicht auf die erste Hauptfläche in einem Randbereich, vorzugsweise insbesondere in einem Eckbereich des Lumineszenzkonversionselements enthalten. Ein Teil der in das Lumineszenzmodul eingekoppelten Primärstrahlung wird vorzugsweise mittels Mehrfachreflexion an der Reflektorfläche zu einem dem Randbereich gegenüberliegenden weiteren Randbereich - etwa einem weiteren Eckbereich wie demjenigen weiteren Eckbereich, der dem Eckbereich diagonal gegenüberliegt - des Lumineszenzkonversionselements geführt. Auf diese Weise ist mit Vorteil der Randbereich, der weitere Randbereich und ein zwischen diesen angeordneter Mittelbereich des Lumineszenzkonversionselements mit Primärstrahlung beleuchtet.

Beispielsweise hat das Lumineszenzkonversionselement in Draufsicht auf seine erste Hauptfläche die Form eines Rechtecks und eine Ausbreitungsrichtung der Primärstrahlung im Einkoppelbereich verläuft in Draufsicht auf die erste Hauptfläche in einem Winkel β zu einer Kante des Rechtecks, der einen Wert 0° < β < 90°, vorzugsweise 1° ≤ β ≤ 45°, zum Beispiel 5° ≤ β ≤ 25°, hat.

Bei einem Strahlenbündel der Primärstrahlung, das kein paralleles Strahlenbündel ist, wird unter dem Begriff "Ausbreitungsrichtung" insbesondere eine Mittelachse des Strahlenkegels verstanden, in dem sich die Primärstrahlung im Einkoppelbereich vor dem Eintritt in das Lumineszenzkonversionselement ausbreitet.

Der Winkel ist vorzugsweise so gewählt, dass in das Lumineszenzkonversionselement eingekoppelte, ungestreute Primärstrahlung nach der ersten spiegelnden Reflexion an der Reflektorschicht nicht in den Einkoppelbereich zurück reflektiert wird.

Bei einer Weiterbildung dieser Ausführungsform erfolgt die Einkopplung von Primärstrahlung in das Lumineszenzkonversionsmodul durch einen wellenlängenselektiven Einkoppelspiegel hindurch. Der wellenlängenselektive Einkoppelspiegel hat einen großen Transmissionskoeffizienten für die Primärstrahlung, insbesondere hat er einen großen Transmissionskoeffizienten im ersten Wellenlängenbereich. Zudem hat der Einkoppelspiegel einen großen Reflexionskoeffizienten für die Sekundärstrahlung, insbesondere einen großen Reflexionskoeffizienten im zweiten Wellenlängenbereich.

Der Einkoppelspiegel bedeckt beispielsweise den Einkoppelbereich der Seitenfläche, welcher von der Reflektorfläche freigelassen ist. Mit Vorteil lenkt der wellenselektive Einkoppelspiegel einen in Richtung des Einkoppelbereichs der Seitenfläche emittierten Anteil der Sekundärstrahlung um, so dass dieser zumindest teilweise durch die Lichtauskoppelfläche emittiert wird.

Bei einer weiteren Ausgestaltung der Halbleiterlichtquelle erfolgt die Auskopplung der Sekundärstrahlung aus dem Lumineszenzkonversionsmodul durch einen wellenlängenselektiven Auskoppelspiegel hindurch. Der wellenlängenselektive Auskoppelspiegel hat einen großen Reflexionskoeffizienten für die Primärstrahlung oder für einen spektralen Anteil der Primärstrahlung, beispielsweise hat er einen großen Reflexionskoeffizienten im ersten Wellenlängenbereich. Zudem hat er einen großen Transmissionskoeffizienten für die Sekundärstrahlung, also insbesondere im zweiten Wellenlängenbereich.

Zweckmäßigerweise ist der wellenlängenselektive Auskoppelspiegel der Lichtauskoppelfläche des Lumineszenzkonversionselement benachbart, insbesondere auf der von der zweiten Hauptfläche abgewandten Seite. Mit anderen Worten ist der Auskoppelspiegel der Lichtauskoppelfläche in einer Abstrahlrichtung des Lumineszenzkonversionsmoduls nachgeordnet. Mit Vorteil reflektiert der Auskoppelspiegel einen nicht konvertierten Anteil der Primärstrahlung in das Lumineszenzkonversionselement zurück, wodurch die Konversionseffizienz mit Vorteil besonders hoch ist.

Falls Auskopplung von Primärstrahlung aus der Halbleiterquelle unerwünscht ist - zum Beispiel wenn der ersten Wellenlängenbereich ultraviolette Strahlung enthält - kann diese mittels des Auskoppelspiegels verringert oder vollständig unterdrückt sein. Bei einer Weiterbildung hält der wellenlängenselektive Auskoppelspiegel nur einen unerwünschten spektralen Anteil der Primärstrahlung zurück, beispielsweise einen kurzwelligen Anteil, und transmittiert einen erwünschten spektralen Anteil der Primärstrahlung, beispielsweise einen längerwelligen Anteil.

Bei einer weiteren Ausgestaltung weist das Lumineszenzkonversionsmodul mindestens ein Kühlelement, beispielsweise eine Kühlrippe, auf, das in das Lumineszenzkonversionselement hinein ragt oder durch das Lumineszenzkonversionselement hindurch ragt und thermisch leitend mit dem Kühlkörper verbunden ist. Zum Beispiel verläuft das Kühlelement quer oder senkrecht zu der ersten Hauptfläche zumindest durch einen Teil des Lumineszenzkonversionselement hindurch. Insbesondere erstreckt sich das Kühlelement in Richtung von der zweiten zur ersten Hauptfläche. Vorzugsweise erstreckt es sich von der zweiten Hauptfläche bis zur ersten Hauptfläche oder über die erste Hauptfläche hinaus. Mittels des mindestens einen Kühlelements ist die Wärmeabfuhr aus dem Lumineszenzkonversionselement weiter verbessert.

Beispielsweise grenzt das Kühlelement auf der dem Kühlkörper zugewandten Seite des Lumineszenzkonversionsmoduls an die Reflektorfläche an. Bei einer Weiterbildung grenzt das Kühlelement alternativ oder zusätzlich an einen Bereich der Reflektorfläche an, welcher die Seitenfläche oder die Seitenflächen des Lumineszenzkonversionselement bedeckt.

Bei einer Ausgestaltung weist das Lumineszenzkonversionsmodul eine Mehrzahl von Kühlrippen auf, die insbesondere kammartig angeordnet sind. Beispielsweise verlaufen die Kühlrippen in Draufsicht auf die erste Hauptfläche parallel zueinander.

Bei einer Ausgestaltung hat das Lumineszenzkonversionselement in Draufsicht auf die erste Hauptfläche die Form eines Rechtecks. Das Lumineszenzkonversionsmodul weist beispielsweise eine Mehrzahl von Kühlelementen auf, die parallel zu zwei gegenüberliegenden Kanten des Rechtecks verlaufen. Jede Kühlrippe grenzt an eine der beiden übrigen Kanten des Rechtecks an und endet in einem Abstand von der zweiten der übrigen zwei Kanten. Die Anordnung der Kühlelemente ist vorzugsweise so gewählt, dass der Strahlengang von ungestreuter Primärstrahlung im Lumineszenzkonversionselement frei von Kühlelementen ist.

Das mindestens eine Kühlelement kann alternativ auch zur spiegelnden oder diffusen Reflexion von Primärstrahlung und/oder Sekundärstrahlung vorgesehen sein. Dazu weist das Kühlelement bei einer Weiterbildung eine zumindest stellenweise reflektierende Oberfläche auf.

Bei einer weiteren Ausgestaltung wird die Primärstrahlung mittels eines optischen Elements in das Lumineszenzkonversionsmodul eingekoppelt. Beispielsweise handelt es sich bei dem optischen Element um einen Spiegel, etwa einen Planspiegel, einen Hohlspiegel oder einen konvexen Spiegel, um eine Sammellinse, um eine Zerstreuungslinse, um einen Lichtleitstab oder um eine Glasfaser. Auch eine optische Anordnung mit einer Mehrzahl von solchen optischen Elementen kann zur Einkopplung von Primärstrahlung in das Lumineszenzkonversionselement vorgesehen sein.

Bei einer Variante dieser Ausgestaltung stellt der wellenlängenselektive Auskoppelspiegel, der einen großen Reflexionskoeffizienten für die Primärstrahlung oder für einen spektralen Anteil der Primärstrahlung und einen großen Transmissionskoeffizienten für die Sekundärstrahlung hat, zugleich das optische Element dar. Bei dieser Variante ist der wellenlängenselektive Auskoppelspiegel insbesondere gekrümmt und/oder er ist schräg zur Lichtauskoppelfläche angeordnet. Zweckmäßigerweise ist er von der Primärstrahlungsquelle beleuchtet.

Die geometrische Anordnung von Primärstrahlungsquelle und Lumineszenzkonversionsmodul und die Krümmung und/oder der Winkel zwischen Auskoppelspiegel und Lichtauskoppelfläche sind insbesondere derart gewählt, dass von der Primärstrahlungsquelle emittierte Primärstrahlung mittels des wellenlängenselektiven Auskoppelspiegels durch die Lichtauskoppelfläche in das Lumineszenzkonversionselement gelenkt und insbesondere umgelenkt ist. Eine Umlenkung der Sekundärstrahlung findet vorzugsweise im Wesentlichen nicht statt.

Beispielsweise sind die Ausbreitungsrichtung der Primärstrahlung und die Lichtauskoppelfläche etwa parallel. Der wellenlängenselektive Auskoppelspiegel zum Beispiel in einem Winkel zwischen 30° und 60°, vorzugsweise in einem Winkel von etwa 45° zur Lichtauskoppelfläche angeordnet.

Bei einer anderen Weiterbildung emittiert die Primärstrahlungsquelle Primärstrahlung in einem divergenten Strahlenbündel und der Lichtauskoppelspiegel ist derart gekrümmt dass er das divergente Strahlenbündel zumindest näherungsweise parallelisiert. Bei dieser Weiterbildung hat der wellenlängenselektive Auskoppelspiegel insbesondere die Form eines Hohlspiegels. Vorzugsweise ist er derart ausgeführt, dass das parallelisierte Strahlenbündel zumindest annähernd senkrecht auf die Lichtauskoppelfläche trifft.

Der wellenlängenselektive Auskoppelspiegel, der zugleich das optische Element darstellt, kann bei einer Weiterbildung von mehreren Primärstrahlungsquellen beleuchtet sein. Beispielsweise weist er mehrere Segmente auf, die jeweils von mindestens einer Primärstrahlungsquelle beleuchtet sind. Zum Beispiel hat der wellenlängenselektive Auskoppelspiegel einen V-förmigen Querschnitt. Alternativ kann er die Form einer Pyramide oder eines Pyramidenstumpfs haben. Die Spitze des "V" oder der Pyramide ist insbesondere der Lichtauskoppelfläche zugewandt. Beim Pyramidenstumpf ist im vorliegenden Zusammenhang "die Spitze der Pyramide" die Spitze derjenigen Pyramide, welche den Pyramidenstumpf vervollständigt. Eine Mittelachse des "V" oder der Pyramide / des Pyramidenstumpfs steht zum Beispiel senkrecht oder im Wesentlichen senkrecht auf der Lichtauskoppelfläche.

Bei einer wiederum anderen Ausgestaltung der Halbleiterlichtquelle umgreift der Kühlkörper das Lumineszenzkonversionselement. Beispielsweise ist ein Teilstück des Kühlkörpers einer Seitenfläche des Lumineszenzkonversionselements zugewandt. Zum Beispiel ist eine L-förmige, V-förmige oder U-förmige Struktur des Kühlkörpers - etwa eine Aussparung - zur Aufnahme des Lumineszenzkonversionselements vorgesehen. Vorzugsweise ist das Lumineszenzkonversionselement zumindest teilweise in einer Vertiefung des Kühlkörpers ausgebildet oder angeordnet.

Beispielsweise wird die Reflektorfläche oder zumindest ein Teil der Reflektorfläche von der Oberfläche der Struktur oder Vertiefung oder von einem Teilgebiet der Oberfläche der Struktur oder Vertiefung gebildet. Bei einer Weiterbildung ist die Primärstrahlungsquelle in einer weiteren Vertiefung oder in einer weiteren L-förmigen, V-förmigen oder U-förmigen Struktur des Kühlkörpers angeordnet. Mit Vorteil ist die Wärmeabfuhr von Lumineszenzkonversionselementen bei dieser Ausgestaltung besonders gut. Zudem wird eine besonders kompakte Bauweise der Halbleiterlichtquelle erzielt.

Weitere Vorteile und vorteilhafte Ausgestaltungen und Weiterbildungen der Halbleiterlichtquelle ergeben sich aus den im Folgenden in Zusammenhang mit den Figuren 1 bis 7 dargestellten exemplarischen Ausführungsbeispielen.

Es zeigen:
- Figur 1,: einen schematischen Querschnitt durch eine Halbleiterlichtquelle gemäß einem ersten Ausführungsbeispiel,
- Figur 2,: einen schematischen Querschnitt durch eine Halbleiterlichtquelle gemäß einem zweiten Ausführungsbeispiel,
- Figur 3A,: einen schematischen Querschnitt durch eine Halbleiterlichtquelle gemäß einem dritten Ausführungsbeispiel,
- Figur 3B,: eine schematische Draufsicht auf die Halbleiterlichtquelle gemäß dem Ausführungsbeispiel der Figur 3A,
- Figur 3C,: eine schematische Draufsicht auf eine Halbleiterlichtquelle gemäß einer Variante des dritten Ausführungsbeispiels,
- Figur 4,: eine schematische Draufsicht auf eine Halbleiterlichtquelle gemäß einem vierten Ausführungsbeispiel,
- Figur 5,: eine schematische Draufsicht auf eine Halbleiterlichtquelle gemäß einem fünften Ausführungsbeispiel,
- Figur 6A,: einen schematischen Querschnitt durch eine Halbleiterlichtquelle gemäß einem sechsten Ausführungsbeispiel,
- Figur 6B,: eine schematische Draufsicht auf die Halbleiterlichtquelle gemäß dem Ausführungsbeispiel der Figur 6A,
- Figur 7,: einen schematischen Querschnitt durch eine Halbleiterlichtquelle gemäß einem siebten Ausführungsbeispiel,
- Figur 8,: einen schematischen Querschnitt durch eine Halbleiterlichtquelle gemäß einem achten Ausführungsbeispiel, und
- Figur 9,: einen schematischen Querschnitt durch eine Halbleiterlichtquelle gemäß einem neunten Ausführungsbeispiel.

In den Ausführungsbeispielen und Figuren sind gleiche oder gleich wirkende Bestandteile mit den gleichen Bezugszeichen versehen. Die Figuren und die Größenverhältnisse der in der Figuren dargestellten Elemente untereinander sind grundsätzlich nicht als maßstabsgetreu zu betrachten. Beispielsweise können einzelne Elemente wie etwa Schichten zur besseren Darstellbarkeit und/oder zum besseren Verständnis übertrieben groß und/oder dick dargestellt sein.

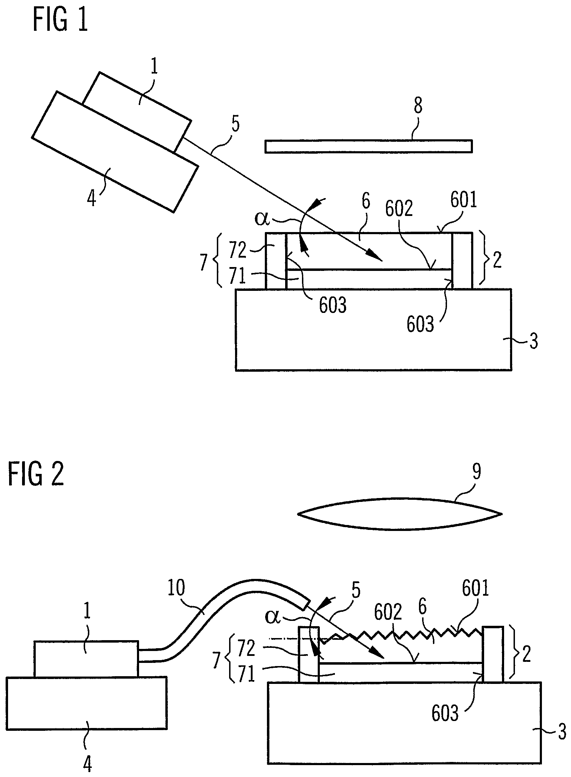

In Figur 1 ist ein erstes Ausführungsbeispiel einer Halbleiterlichtquelle schematisch im Querschnitt gezeigt. Die Halbleiterlichtquelle weist eine Primärstrahlungsquelle 1 und ein Lumineszenzkonversionsmodul 2 auf. Das Lumineszenzkonversionsmodul 2 ist an einem Kühlkörper 3 angeordnet. Die Primärstrahlungsquelle 1 ist bei dem ersten Ausführungsbeispiel an einem weiteren Kühlkörper 4 angeordnet.

Bei der Primärstrahlungsquelle 1 handelt es sich beispielsweise um einen Laserdiodenchip, der zum Beispiel Primärstrahlung 5 in einem ersten Wellenlängenbereich, etwa im blauen oder ultravioletten Spektralbereich, emittiert. Die von dem Laserdiodenchip emittierte Strahlungsleistung ist beispielsweise größer oder gleich 1 Watt.

Das Lumineszenzkonversionsmodul 2 enthält ein Lumineszenzkonversionselement 6, das einen anorganischen Leuchtstoff enthält. Mittels des Leuchtstoffes konvertiert das Lumineszenzkonversionselement 6 Primärstrahlung aus dem ersten Wellenlängenbereich in elektromagnetische Sekundärstrahlung in einem zweiten Wellenlängenbereich, der von dem ersten Wellenlängenbereich verschieden ist. Der Leuchtstoff wird von der Primärstrahlung 5 insbesondere zu Fluoreszenz und/oder Phosphoreszenz angeregt.

Der Leuchtstoff ist beispielsweise ausgewählt aus mindestens einem Element der Gruppe, die Granat-Leuchtstoffe wie mit einem Selten-Erd-Material dotiertes Yttrium-Aluminium-Granat (YAG) - zum Beispiel YAG:Ce -, Aluminat-Leuchtstoffe, Orthosilikat-Leuchtstoffe, nitridische Leuchtstoffsysteme - etwa Nitridosilikate und Oxinitride -, Erdalkalisulfid-Leuchtstoffe und Thiogallat-Leuchtstoffe umfasst.

Für einen ersten Wellenlängenbereich der nahe UV-Strahlung umfasst, sind beispielsweise Leuchtstoffe auf Oxidbasis geeignet, zum Beispiel Barium-Magnesium-Aluminate, die mit Europium dotiert sind, etwa BaMgAl₁₀O₁₇:Eu²⁺. Alternativ oder zusätzlich sind auch Strontium-Magnesium-Aluminate, die ebenfalls mit Europium dotiert sind, wie zum Beispiel SrMgAl₁₀O₁₇:EU²⁺ sowie Chlorapatite mit Strontium, Barium oder Calcium der Formel (Sr, Ba, Ca)₅(PO₄)₃Cl:Eu²⁺ geeignet. Es können auch Bariumaluminate, zum Beispiel Ba₃Al₂₈O₄₅:Eu²⁺ verwendet werden. All die genannten Verbindungen emittieren Licht im blauen Wellenlängenbereich, wenn sie im nahen UV gepumpt werden. Grün emittierende Leuchtstoffe sind beispielsweise SrAl₂O₄:Eu²⁺. Grün bis grüngelb emittierende Leuchtstoffe sind beispielsweise Chloro-Silikate, die mit Europium oder Mangan dotiert sind, etwa Chloro-Silikate der Formeln Ca₈Mg(SiO₄)₄Cl₂:Eu²⁺ oder Ca₈Mg(SiO₄)₄Cl₂:Mn²⁺, sowie Thiogallate der allgemeinen Formel AGa₂S₄:Eu²⁺ oder AGa₂S₄:Ce²⁺, wobei A insbesondere ausgewählt ist aus der Gruppe: Calcium, Strontium, Barium, Zink und Magnesium. Weiterhin können als rot emittierende Leuchtstoffe und Konvertermaterialien beispielsweise Erdalkali-substituierte Strontium-Sulfide der allgemeinen Formel (A, Sr)S:Eu²⁺ mit A= Erdalkalimetallionen.

Als Leuchtstoff, der beispielsweise im roten Spektralbereich emittiert, ist auch ein nitridisches Leuchtstoffsystem geeignet. Zum Beispiel handelt es sich bei dem nitridischen Leuchtstoffsystem um ein Nitridosilikat, etwa M₂Si₅N₈:Eu²⁺ mit einem Erdalkalimetall M wie Ba, Ca oder Sr. Alternativ oder zusätzlich kann ein mit einem Selten-Erd Material dotierter Aluminiumsiliziumnitrid-Leuchtstoff verwendet sein, etwa
MAlSiN₃:SE, wobei M insbesondere für ein Erdalkalimetall wie Ba, Sr, Ca und SE für eine Seltene Erde steht. Insbesondere für den grünen Spektralbereich sind zum Beispiel Oxinitride wie MSi₂O₂N₂:Eu²⁺, wobei M beispielsweise für ein Erdalkalimetall wie Ba, Ca, Sr steht, geeignet.

Für die Halbleiterlichtquelle gemäß dem vorliegenden Ausführungsbeispiel und für die anderen Ausgestaltungen der Halbleiterlichtquelle sind Orthosilikat-Leuchtstoffe, zum Beispiel mit der allgemeinen Formel M₂SiO₄:SE - wobei M beispielsweise für ein Erdalkalimetall wie Mg, Ca, Sr, Ba und SE für eine Seltene Erde wie Europium (Eu²⁺) steht -, besonders gut geeignet. Orthosilikat-Leuchtstoffe haben in der Regel eine besonders hohe Effizienz. Zwar besteht bei Orthosilikat-Leuchtstoffen eine große Gefahr, dass das Emissionsverhalten des Leuchtstoffs durch Temperaturschwankungen, insbesondere durch eine Temperaturerhöhung, beeinträchtigt wird. Bei der Halbleiterlichtquelle gemäß der vorliegenden Anmeldung ist diese Gefahr jedoch mit Vorteil reduziert oder beseitigt. Orthosilikat-Leuchtstoffe konvertieren beispielsweise elektromagnetische Strahlung in den grünen, gelben und/oder gelb/orangen Spektralbereich.

Bei einer Ausgestaltung ist in dem Lumineszenzkonversionselement 6 ein Leuchtstoffgemisch enthalten, das beispielsweise Strontium-Chlorapatit, Strontium-Aluminat und Nitridosilikate enthält. Beispielsweise enthält es 47 Gew-% Strontium-Chlorapatit, 48 Gew-% Strontium-Aluminat und 5 Gew-% Nitridosilikate enthält. Ein solches Leuchtstoffgemisch ist bei einer zweckmäßigen Ausgestaltung dazu vorgesehen Weißlicht zu emittieren, insbesondere bei einer Anregung mit Primärstrahlung 5 einer ersten Wellenlänge von 405 nm. Das Weißlicht hat zum Beispiel einen Farbort x = 0,354 und y = 0,386 in der CIE-Norm Farbtafel.

Das Lumineszenzkonversionselement 6 ist vorliegend durch eine Platte des zu einem keramischen Material gesinterten Leuchtstoffes gebildet. Die Platte hat in Draufsicht die Form eines Rechtecks oder Quadrats. Alternativ kann sie auch in Draufsicht die Form eines Polygons, einer Kreisfläche, einer ellipsenförmigen Fläche oder eines Segments einer Kreisfläche oder ellipsenförmigen Fläche aufweisen.

Das Lumineszenzkonversionsmodul weist weiter eine Reflektorschicht 7 auf, die sich vorliegend aus zwei Teilbereichen 71, 72 zusammensetzt. Der erste Teilbereich 71 der Reflektorschicht 7 ist zwischen dem Lumineszenzkonversionselement 6 und dem Kühlkörper 3 angeordnet. Er bedeckt vorliegend eine zweite Hauptfläche 602 des Lumineszenzkonversionselement 6 vollständig. Der zweite Teilbereich 72 der Reflektorschicht 7 bedeckt vorliegend die Seitenflächen 603 des Lumineszenzkonversionselement 6 vollständig. Die von der Reflektorschicht 7 unbedeckte erste Hauptfläche 601 des Lumineszenzkonversionselement 6 stellt dessen Lichtauskoppelfläche dar. Sie liegt der zweiten Hauptfläche 602 gegenüber, welche vorliegend dem Kühlkörper 3 zugewandt ist. Zumindest die dem Lumineszenzkonversionselement 6 zugewandten Innenflächen der Reflektorschicht sind reflektierend, insbesondere spiegelnd ausgebildet.

Vorliegend handelt es sich bei der Reflektorschicht 7 um eine Schichtenfolge aus einer dielektrischen Schicht und einer metallischen Schicht. Das keramische Material des Lumineszenzkonversionselements 6 ist zumindest an den Seitenflächen 603 und der zweiten Hauptfläche 602 mit der dielektrischen Schicht, etwa einer Siliziumoxidschicht, insbesondere einer Siliziumdioxidschicht, als Planarisierungsschicht versehen, die metallische Schicht ist auf die dielektrische Planarisierungsschicht aufgedampft. Die Schichtdicke der Reflektorschicht beträgt vorliegend 50 nm oder weniger. Der Verbund von Lumineszenzkonversionselement 6 und Reflektorschicht 7 ist, beispielsweise mittels einer Klebstoffschicht oder, bevorzugt, mittels einer Lotschicht, an dem Kühlkörper 3 befestigt.

Alternativ kann die Reflektorschicht 7 oder zumindest der erste Teilbereich 71 der Reflektorschicht 7 auch an dem Kühlkörper 3 ausgebildet sein, beispielsweise ist der erste Teilbereich 71 der Reflektorschicht 7 auf den Kühlkörper 3 aufgedampft. Dies ist insbesondere bei Ausgestaltungen des Lumineszenzkonversionsmoduls 2 vorteilhaft, bei denen das Lumineszenzkonversionselement 6 beispielsweise elektrophoretisch oder mittels eines Druck-Prozesses auf dem ersten Teilbereich 71 abgeschieden ist.

Bei einer anderen Ausgestaltung weist der zweite Teilbereich der Reflektorschicht 7 mindestens eine Reflektorplatte oder mindestens ein Reflektorband auf, die/das insbesondere ein Metall aufweisen und/oder spiegelnd beschichtet sind. Die Reflektorplatte und/oder das Reflektorband ist/sind beispielsweise mit der mindestens einen Seitenfläche 603 verklebt, etwa mittels eines Silikon-Harzes.

Von der Primärstrahlungsquelle 1 emittierte Primärstrahlung 5 wird unter einem Winkel α zur ersten Hauptfläche 601 in das Lumineszenzkonversionselement 6 eingekoppelt. Dort wird sie von dem Leuchtstoff zumindest teilweise absorbiert, so dass das Lumineszenzkonversionselement 6 Sekundärstrahlung emittiert, die durch die erste Hauptfläche 601 ausgekoppelt wird.

Sekundärstrahlung die nicht in Richtung der ersten Hauptfläche 601 sondern in Richtung der Reflektorschicht 7 von dem Lumineszenzkonversionselement emittiert wird, wird zumindest teilweise von der Reflektorschicht 7 in Richtung der ersten Hauptfläche 601 reflektiert. Zudem ist die Reflektorschicht 7 vorliegend dazu vorgesehen, in das Lumineszenzkonversionselement 6 eingekoppelte Primärstrahlung 5, die auf dem Weg von der ersten Hauptfläche 601 zur zweiten Hauptfläche 602 nicht von dem Leuchtstoff absorbiert wird, an dem ersten Teilbereich 71 und/oder dem zweiten Teilbereich 72 der Reflektorschicht 7 in das Lumineszenzkonversionselement 6 zurück zu reflektieren.

Der ersten Hauptfläche 601 ist ein wellenlängenselektiver Auskoppelspiegel 8 nachgeordnet. Der Auskoppelspiegel 8 ist von der ersten Hauptfläche 601 beabstandet, so dass die Strahlführung der Primärstrahlung 5 zur Einkopplung in das Lumineszenzkonversionselement 6 durch den Bereich zwischen erster Hauptfläche 601 und Auskoppelspiegel 8 erfolgt.

Der Lichtauskoppelspiegel 8 hat einen hohen Transmissionskoeffizienten für die vom Lumineszenzkonversionselement 6 emittierte Sekundärstrahlung und einen hohen Reflexionskoeffizienten für die Primärstrahlung 5. Auf diese Weise wird beispielsweise an der ersten Hauptfläche 601 reflektierte Primärstrahlung 5 wieder in Richtung des Lumineszenzkonversionselement 6 zurückreflektiert. Der wellenlängenselektive Lichtauskoppelspiegel 8 ist zudem vorteilhaft, wenn der Austritt von unkonvertierter Primärstrahlung 5 aus der Halbleiterlichtquelle unerwünscht ist, beispielsweise bei einem ersten Wellenlängenbereich, der UV-Licht umfasst.

Figur 2 zeigt einen schematischen Querschnitt einer Halbleiterlichtquelle gemäß einem zweiten Ausführungsbeispiel. Im Unterschied zum ersten Ausführungsbeispiel wird Primärstrahlung der Primärstrahlungsquelle 1 bei dem zweiten Ausführungsbeispiel mittels eines optischen Elements 10 in das Lumineszenzkonversionselement 6 eingekoppelt. Bei dem optischen Element 10 handelt es sich vorliegend um einen Lichtleiter wie eine Glasfaser. Mittels der Glasfaser 10 kann die Position der Primärstrahlungsquelle 1 im Wesentlichen unabhängig vom Einkoppelwinkel α gewählt werden.

Ein weiterer Unterschied zu dem ersten Ausführungsbeispiel ist, dass die erste Hauptfläche 601 bei dem zweiten Ausführungsbeispiel aufgeraut ist. Beispielsweise wird an der aufgerauten ersten Hauptfläche 601 ein Teil der Primärstrahlung 5 in das Lumineszenzkonversionselement 6 eingekoppelt und ein weiterer Teil der Primärstrahlung 5 in Richtung von dem Lumineszenzkonversionselement weg gestreut. Die Halbleiterlichtquelle emittiert dann elektromagnetische Strahlung, die unkonvertierte Primärstrahlung der Primärstrahlungsquelle 1 und konvertierte Sekundärstrahlung des Lumineszenzkonversionsmoduls 2 enthält.

Vorliegend wird diese Mischstrahlung, beziehungsweise zumindest die Sekundärstrahlung, falls eine Auskopplung von Primärstrahlung 5 nicht erwünscht ist, durch ein Strahlformungselement 9, etwa eine Sammellinse, ein System von Linsen, Spiegeln und/oder Lichtleitern hindurch ausgekoppelt.

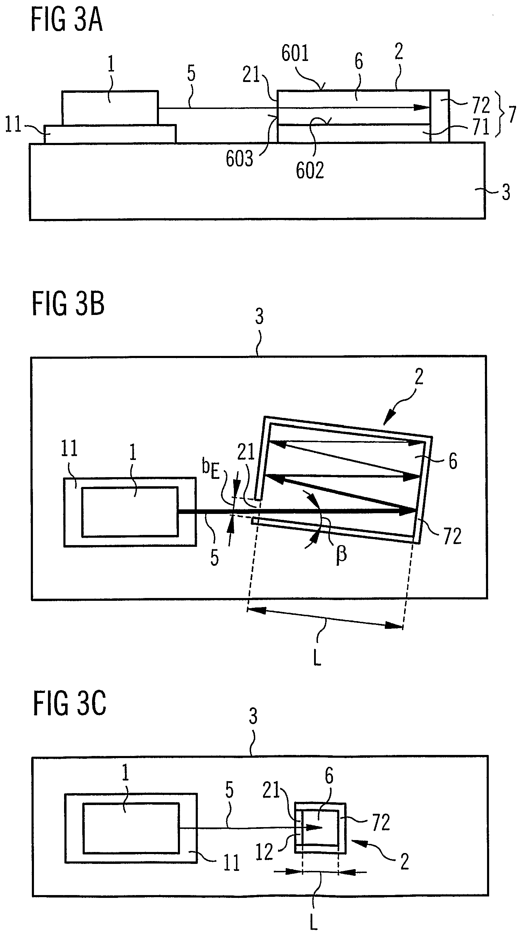

In den Figuren 3A und 3B ist ein drittes Ausführungsbeispiel einer Halbleiterlichtquelle in einem schematischen Querschnitt (Fig. 3A) und einer schematischen Draufsicht (Fig. 3B) dargestellt. Im Unterschied zu den vorhergehenden Ausführungsbeispielen ist bei dem dritten Ausführungsbeispiel die Primärstrahlungsquelle 1 nicht auf einem separaten Kühlkörper 4 angeordnet, sondern sie ist auf demselben Kühlkörper 3 angeordnet wie des Lumineszenzkonversionsmodul 2.

Zudem wird Primärstrahlung 5 nicht durch die Lichtauskoppelfläche 601 des Lumineszenzkonversionselements in das Lumineszenzkonversionselement 6 eingekoppelt. Vielmehr erfolgt die Einkopplung in einem Einkoppelbereich 21 durch eine Seitenfläche 603. Der zweite Teilbereich 72 der Reflektorschicht 7 bedeckt die Seitenflächen 603 des Lumineszenzkonversionselement 6 bis auf den Einkoppelbereich 21 vollständig. Der Einkoppelbereich 21 ist in Draufsicht auf die Lichtauskoppelfläche 601 in einem Randbereich des Lumineszenzkonversionselements 6 angeordnet.

Das Lumineszenzkonversionselement 6 hat in Draufsicht auf seine erste Hauptfläche 601 die Form eines Rechtecks. Eine Ausbreitungsrichtung der Primärstrahlung verläuft in Draufsicht auf die erste Hauptfläche 601 in einem Winkel β zu einer Kante des Rechtecks, wobei insbesondere gilt: 0° < β < 90°, vorzugsweise 1° ≤ β ≤ 45°, zum Beispiel 5° ≤ β ≤ 25°.

Bei einem Strahlenbündel der Primärstrahlung, das kein paralleles Strahlenbündel ist, wird unter dem Begriff "Ausbreitungsrichtung" vorliegend eine Mittelachse des Strahlenkegels verstanden, in dem sich die Primärstrahlung 5 ausbreitet. Verläuft die Primärstrahlung 5 vor der Einkopplung in das Lumineszenzkonversionsmodul 2 durch ein optisches Element 10 hindurch, ist die Ausbreitungsrichtung im Einkoppelbereich 21 maßgeblich.

Der Winkel β ist vorzugsweise so gewählt, dass ungestreute Primärstrahlung 5, die nach der Einkopplung im Einkoppelbereich 21 durch das Lumineszenzkonversionselement 6 verläuft nach der ersten spiegelnden Reflexion an den zweiten Teilbereich 72 der Reflektorschicht 7 nicht in den Einkoppelbereich 21 zurück reflektiert wird.

Ist L die Länge der Kanten des Rechtecks, die senkrecht zu der vom Einkoppelbereich 21 gehörenden Kante verlaufen, B_{E} die Breite des nicht verspiegelten Einkoppelbereichs 21, n_{A} der Brechungsindex im Einkoppelbereich 21 außerhalb des Lumineszenzkonversionselements 6 und n_{I} der Brechungsindex im Lumineszenzkonversionselement 6 gilt für den Winkel β vorzugsweise: β ≥ arcsin [(n_{I}B_{E}) / (2n_{A}L)].

Auf diese Weise wird ungestreute Primärstrahlung 5 mittels Mehrfachreflexion am zweiten Teilbereich 72 der Reflektorfläche 7 im Zickzack über einen Mittelbereich des Lumineszenzkonversionselements 6 zu einem dem Randbereich gegenüberliegenden weiteren Randbereich geleitet, angedeutet durch die Pfeile in Figur 3B. Bei jedem Durchlauf durch das Lumineszenzkonversionselement 6 wird ein Teil der Primärstrahlung 5 absorbiert und in Sekundärstrahlung wellenlängenkonvertiert.

Mittels der Mehrfachreflexion kann eine besonders effiziente Ausnutzung des Leuchtstoffs erzielt werden. Insbesondere ist - beispielsweise im Vergleich zu einem Lumineszenzkonversionselement, welches von der Primärstrahlung nur einmal durchlaufen wird - die für die Konversion erforderliche Leuchtstoffmenge reduziert. Auf diese Weise ist eine besonders kostengünstige Herstellung der Halbleiterlichtquelle möglich. Zugleich kann aufgrund der Mehrfachreflexion eine besonders gute räumliche Homogenität der Sekundärstrahlung erzielt werden.

Bei dem dritten Ausführungsbeispiel ist die Primärlichtquelle 1 auf einem Sockel 11 angeordnet. Mittels des Sockels 11 ist der Abstand der Primärlichtquelle 1 von dem Kühlkörper 3 derart angepasst, dass die Ausbreitungsrichtung der Primärstrahlung 5 etwa in einer Mittelebene des Lumineszenzkonversionselements 6 liegt. Die Mittelebene verläuft insbesondere parallel zur ersten und zweiten Hauptfläche 601, 602 und hat von diesen jeweils den gleichen Abstand.

Bei der in Figur 3C dargestellten Variante des dritten Ausführungsbeispiels weist der Einkoppelbereich 21 einen wellenlängenselektiven Einkoppelspiegel 12 auf. Der Einkoppelspiegel 12 hat einen hohen Transmissionskoeffizienten für den ersten Wellenlängenbereich, also für die Primärstrahlung 5, und einen hohen Reflexionskoeffizienten für den zweiten Wellenlängenbereich, also für die Sekundärstrahlung des Lumineszenzkonversionselement 6. Mittels des Einkoppelspiegels 12 wird eine besonders homogene Leuchtdichte des Lumineszenzkonversionselement 6 erzielt.

Während die Ausdehnung L des Lumineszenzkonversionselement 6 in Draufsicht auf seine erste Hauptfläche 601 bei dem dritten Ausführungsbeispiel beispielsweise größer oder gleich 1 mm, zum Beispiel zwischen 1 und 50 mm und insbesondere zwischen 2 und 30 mm, beträgt, ist die laterale Ausdehnung des Lumineszenzkonversionselements 6 der Variante des dritten Ausführungsbeispiels gemäß Figur 3C kleiner oder gleich 0,5 mm, vorzugsweise kleiner oder gleich 100 pm, beispielsweise beträgt sie 10 µm oder weniger.

Die Halbleiterlichtquelle stellt bei dieser Variante in guter Näherung eine Punktlichtquelle dar, die besonders einfach optisch abgebildet werden kann. Mittels der Kombination von Reflektorschicht 7 und Kühlkörper 3 wird Verlustwärme besonders gut vom Lumineszenzkonversionselement 6 abgeführt, so dass das Lumineszenzkonversionsmodul 2 zur Einkopplung von Primärstrahlung 5 mit einer hohen Energiedichte geeignet ist und die Halbleiterlichtquelle eine besonders hohe Leuchtdichte hat.

Insbesondere sind Primärstrahlungsquellen 1 für die Halbleiterlichtquelle gemäß diesem Ausführungsbeispiel oder einer anderen Ausgestaltung gut geeignet, die beispielsweise Primärstrahlung 5 mit einer Strahlungsleistung von größer oder gleich 0,5 Watt, bei einer Weiterbildung Primärstrahlung 5 mit einer Strahlungsleistung von größer oder gleich 1 Watt emittieren. Insbesondere bei einem Lumineszenzkonversionselement mit einer kleinen lateralen Ausdehnung, beispielsweise von 100 µm oder weniger und insbesondere von 10 µm oder weniger, ist auch eine Primärstrahlungsquelle 1 mit einer kleineren Strahlungsleistung - zum Beispiel von größer oder gleich 0,2 W oder von größer oder gleich 0,1 W - zur Erzielung einer hohen Leuchtdichte der Halbleiterlichtquelle gut geeignet.

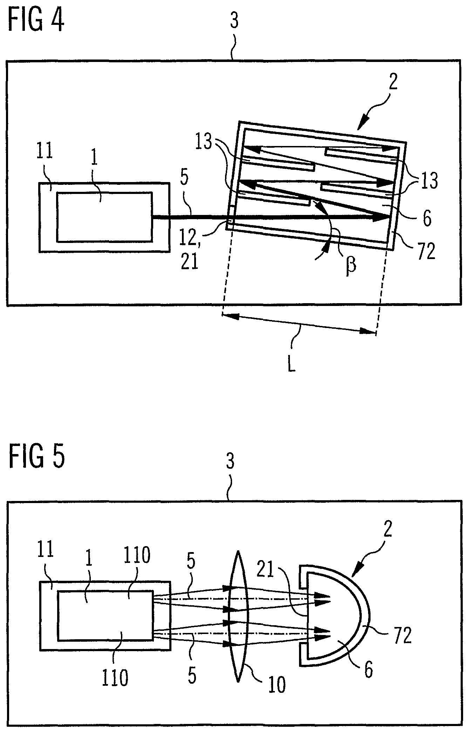

Figur 4 zeigt ein viertes Ausführungsbeispiel der Halbleiterlichtquelle. Das Lumineszenzkonversionsmodul 2 der Halbleiterlichtquelle gemäß dem vierten Ausführungsbeispiel weist im Unterschied zu der Halbleiterlichtquelle gemäß dem dritten Ausführungsbeispiel einen wellenlängenselektiven Einkoppelspiegel 12 auf, beispielsweise einen verteilten Bragg-Reflektor (DBR, distributed bragg reflector). Der wellenlängenselektive Einkoppelspiegel 12 ist im Einkoppelbereich 21 angeordnet, wie bei der Variante des dritten Ausführungsbeispiels gemäß Figur 3C.

Zudem weist das Lumineszenzkonversionsmodul 2 eine Mehrzahl von Kühlrippen 13 auf. Die Kühlrippen 13 erstrecken sich von der zweiten Hauptfläche 602 zur ersten Hauptfläche 601 über die gesamte Dicke des Lumineszenzkonversionselement 6. Sie sind thermisch leitend mit dem ersten Teilbereich 71 der Reflektorschicht 7 verbunden.

Eine erste Mehrzahl von Kühlrippen 13 grenzt an der Seite, die den Einkoppelbereich 21 umfasst an den zweiten Teilbereich 72 der Reflektorschicht 7 an. Die übrigen Kühlrippen 13 grenzen an der gegenüberliegenden Seite an den zweiten Teilbereich 72 an. Die Kühlrippen 13 verlaufen vorliegend parallel zu den beiden übrigen Seiten des von dem Lumineszenzkonversionselement 6 in Draufsicht gebildeten Rechtecks. Ihre Länge ist beispielsweise kleiner oder gleich der Hälfte der Länge L dieser Seiten.

Die erste Mehrzahl von Kühlrippen 13 und die übrigen Kühlrippen 13 sind gegeneinander versetzt, so dass sie einander in Art eines offenen Reißverschlusses gegenüberstehen. Die Kühlrippen 13 sind so angeordnet, dass Primärstrahlung, die in Ausbreitungsrichtung in das Lumineszenzkonversionselement 6 eingekoppelt wird, bei spiegelnder Reflexion am seitlichen Teilbereich 72 der Reflektorschicht 7 und unter Vernachlässigung der Streuung und Absorption am Lumineszenzkonversionselement 6 einen Strahlengang hat, der frei von Kühlrippen 13 ist.

Figur 5 zeigt eine schematische Draufsicht auf eine Halbleiterlichtquelle gemäß einem fünften Ausführungsbeispiel. Bei diesem Ausführungsbeispiel hat das Lumineszenzkonversionselement 6 in Draufsicht auf seine erste Hauptfläche 601 die Form eines Ellipsensegments, insbesondere die Form einer entlang einer der Hauptachsen halbierten ellipsenförmigen Fläche.

Die Primärstrahlungsquelle 1 enthält vorliegend eine Mehrzahl von Laserdioden 110, beispielsweise enthält sie einen Laserdioden-Barren. Die Laserdioden 110 emittieren Primärstrahlung 5 in divergenten Strahlenbündeln, die von einer Sammellinse 10 fokussiert und auf den Einkoppelbereich des Lumineszenzkonversionselement 6 gerichtet werden. Die Ausbreitungsrichtung der Primärstrahlung, also die Mittelachse der Strahlenbündel, ist in Figur 5 mit strichpunktierten Linien angedeutet.

Im Gegensatz zum dritten und vierten Ausführungsbeispiel hat der Einkoppelbereich 21 eine Breite B_{E}, die beispielsweise größer oder gleich der halben Länge der Seitenfläche 603 ist, in welche die Einkopplung der Primärstrahlung 5 in das Lumineszenzkonversionselement 6 erfolgt. Der relativ große Einkoppelbereich 21 wird mittels der Mehrzahl von Laserdioden 110 der Primärstrahlungsquelle 1 vorteilhafterweise besonders gleichmäßig beleuchtet.

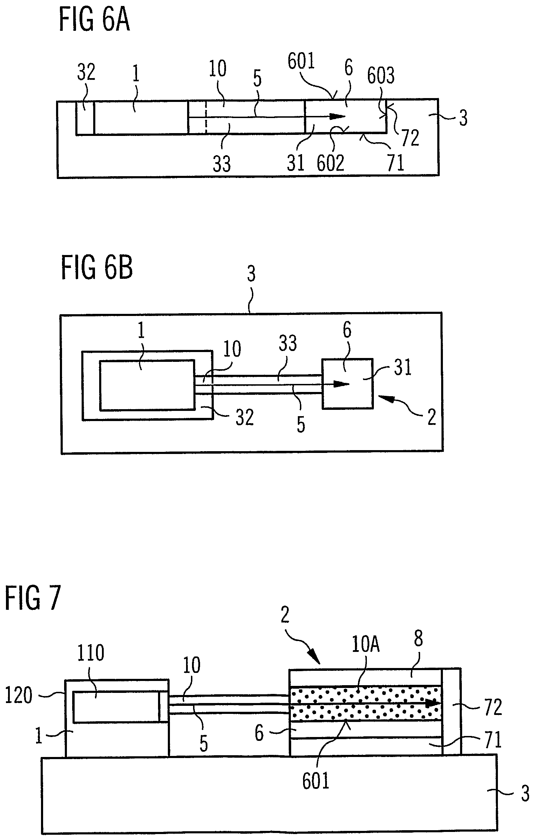

Bei dem in den Figuren 6A und 6B schematisch im Querschnitt (Fig. 6A) und in Draufsicht (Fig. 6B) dargestellten sechsten Ausführungsbeispiel der Halbleiterlichtquelle weist der Kühlkörper 3 eine Vertiefung 31 auf, deren Innenfläche die Reflektorfläche 7 bildet. Eine Bodenfläche der Vertiefung 31 stellt den ersten Teilbereich 71 der Reflektorfläche 7 dar, die Seitenwände der Vertiefung 31 stellen den zweiten Teilbereich 72 der Reflektorfläche 7 dar. Das Lumineszenzkonversionselement 6 ist teilweise oder vollständig in der Vertiefung 31 angeordnet. Vorzugsweise ragt es nicht über den Rand der Vertiefung 31 hinaus.

Die Primärstrahlungsquelle 1 ist vorliegend in einer weiteren Vertiefung 32 des Kühlkörpers 3 angeordnet. Auf diese Weise emittiert die Primärstrahlungsquelle 1 Primärstrahlung 5 in einer Ebene, die durch das Lumineszenzkonversionselement 6 hindurch verläuft.

Die Vertiefungen 31, 32 sind durch eine Rinne 33 in dem Kühlkörper 3 miteinander verbunden, durch welche Primärstrahlung 5 von der Primärstrahlungsquelle 1 zum Lumineszenzkonversionsmodul 2 geführt wird. In der Rinne 33 kann beispielsweise ein optisches Element, vorliegend ein Lichtleitstab 10, angeordnet sein. Mittels des Lichtleitstabs wird die Primärstrahlung 5 besonders verlustarm zu dem Lumineszenzkonversionselement 6 geführt.

Figur 7 zeigt einen schematischen Querschnitt durch eine Halbleiterlichtquelle gemäß einem siebten Ausführungsbeispiel. Bei dem siebten Ausführungsbeispiel weist die Primärstrahlungsquelle 1 eine Leuchtdiode 110 in einem Gehäuse 120 auf. Das Gehäuse 120 des Leuchtdiodenbauelements ist auf demselben Kühlkörper 3 montiert wie das Lumineszenzkonversionsmodul 2.

Die Führung der Primärstrahlung 5 zum Lumineszenzkonversionsmodul 2 erfolgt wie beim sechsten Ausführungsbeispiel mittels eines Lichtleitstabs 10. Anders als beim dritten bis sechsten Ausführungsbeispiel verläuft die Ausbreitungsrichtung der Primärstrahlung 5 jedoch nicht durch das Lumineszenzkonversionselement 6 hindurch. Stattdessen wird bei dem vorliegenden Ausführungsbeispiel Primärstrahlung 5 in eine Lichtleitplatte 10A des Lumineszenzkonversionsmoduls 2 eingekoppelt. Die Lichtleitplatte 10A ist zwischen der ersten Hauptfläche 601 des Lumineszenzkonversionselement 6 und einem wellenlängenselektiven Auskoppelspiegel 8 angeordnet. Der wellenlängenselektive Auskoppelspiegel 8 reflektiert beispielsweise vorliegend einen kurzwelligen, etwa ultravioletten Anteil der Primärstrahlung und hat einen hohen Transmissionskoeffizienten im sichtbaren Spektralbereich. Insbesondere transmittiert der Auskoppelspiegel 8 einen längerwelligen Anteil der Primärstrahlung 5.

Der zweite Teilbereich 72 der Reflektorschicht 7 erstreckt sich vorliegend nicht nur über die Seitenflächen des Lumineszenzkonversionselement 6 sondern auch über die Seitenflächen der Lichtleitplatte 10A. Auf diese Weise wird Primärstrahlung 5 über die gesamte Lichtleitplatte 10A oder zumindest über einen großen Bereich der Lichtleitplatte 10A verteilt.

Die Primärstrahlung 5 wird in der Lichtleitplatte 10A gestreut. Beispielsweise enthält die Lichtleitplatte 10A zu diesem Zweck Diffusorpartikel.

Ein Teil der Primärstrahlung 5 wird in Richtung des Lumineszenzkonversionselement 6 gestreut, über dessen erste Hauptfläche 601 in das Lumineszenzkonversionselement 6 eingekoppelt und von dem Leuchtstoff zu Sekundärstrahlung eines zweiten Wellenlängenbereichs wellenlängenkonvertiert. Ein weiterer Teil der Primärstrahlung 5 wird in Richtung des Auskoppelspiegels 8 gestreut. Die Halbleiterlichtquelle emittiert vorliegend Mischlicht, das aus Primärstrahlung 5 und Sekundärstrahlung besteht. Beispielsweise liegen der von dem Lichtauskoppelspiegel 8 transmittierte Anteil der Primärstrahlung 5 und die Sekundärstrahlung in zueinander komplementären Wellenlängenbereichen, so dass die Halbleiterlichtquelle Licht emittiert, das einen weißen Farbeindruck erzeugt.

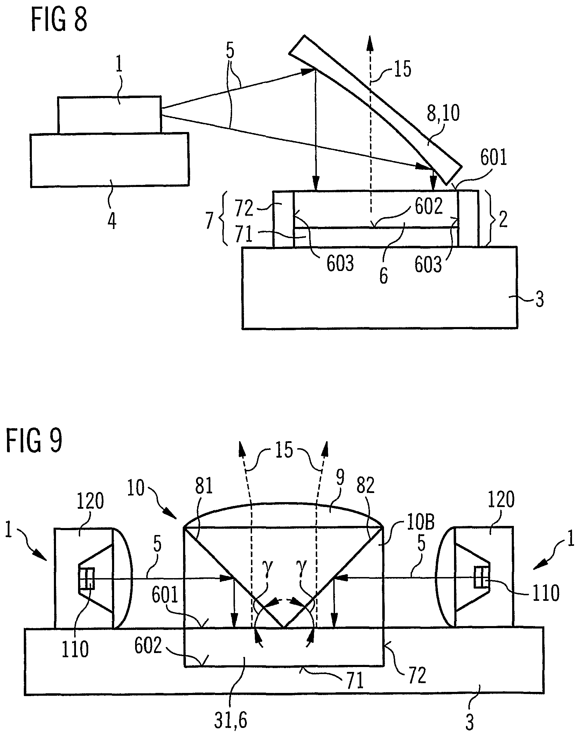

Figur 8 zeigt einen schematischen Querschnitt durch eine Halbleiterlichtquelle gemäß einem achten exemplarischen Ausführungsbeispiel.

Die Halbleiterlichtquelle enthält ein Lumineszenzkonversionsmodul 2 auf einem Kühlkörper 3, zum Beispiel in einer Ausgestaltung analog zu dem ersten Ausführungsbeispiel.

Im Gegensatz zum ersten Ausführungsbeispiel ist der wellenlängenselektive Auskoppelspiegel 8 vorliegend nicht parallel zur Lichtauskoppelfläche 601. Vielmehr ist der wellenlängenselektive Auskoppelspiegel 8 schräg zur Lichtauskoppelfläche 601 angeordnet. Auf diese Weise lenkt er von der Primärstrahlungsquelle emittierte Primärstrahlung 5 um, so dass diese zumindest teilweise auf die Lichtauskoppelfläche 601 trifft und durch diese in das Lumineszenzkonversionselement 6 eingekoppelt wird. Der wellenlängenselektive Auskoppelspiegel 8 stellt damit zugleich ein optisches Element 10 dar, mittels welchem die Primärstrahlung 5 in das Lumineszenzkonversionsmodul 2 eingekoppelt wird.

Bei dem vorliegenden Ausführungsbeispiel ist das optische Element 10 als wellenlängenselektiver Hohlspiegel ausgeführt. Die Krümmung und Ausrichtung des Hohlspiegels 10 sind dabei derart gewählt, dass das von der Primärstrahlungsquelle 1 emittierte divergente Primärstrahlungs-Bündel 5 von dem Hohlspiegel 10 in ein annähernd senkrecht auf die Lichtauskoppelfläche 601 auftreffendes paralleles Strahlenbündel konvertiert wird. Die von dem Lumineszenzkonversionselement 6 emittierte Sekundärstrahlung 15 wird von dem Hohlspiegel vorzugsweise nicht reflektiert.

Die Primärstrahlungsquelle 1 enthält bei dem achten Ausführungsbeispiel mindest einen Leuchtdiodenchip, der Primärstrahlung 5 im ultravioletten Spektralbereich emittiert.

In Figur 9 ist eine Halbleiterlichtquelle gemäß einem neunten exemplarischen Ausführungsbeispiel in einem schematischen Querschnitt dargestellt.

Das Lumineszenzkonversionselement 6 ist bei diesem Ausführungsbeispiel wie beim sechsten Ausführungsbeispiel (sieh Figuren 6A und 6B) in einer Vertiefung 31 des Kühlkörpers 3 angeordnet. Im Gegensatz zum sechsten Ausführungsbeispiel ist das Lumineszenzkonversionselement vorliegend seitlich vollständig von den Seitenwänden 72 der Vertiefung 31 umschlossen.

Die Halbleiterlichtquelle weist vorliegend eine Mehrzahl von Primärstrahlungsquellen 1, beispielsweise zwei Primärstrahlungsquellen 1 auf. Diese enthalten zum Beispiel wie beim achten Ausführungsbeispiel jeweils mindestens einen Leuchtdiodenchip 110 der zum Beispiel ein Emissionsmaximum im ultravioletten Spektralbereich hat. Vorliegend sind die Leuchtdiodenchips 110 jeweils in einem Bauelementgehäuse enthalten, welches eine optische Anordnung mit einem Reflektor und einer Linse zur Strahlformung aufweist. Die Primärstrahlungsquellen 1 sind beispielsweise an einer Fläche des Kühlkörpers 3 befestigt, welche die Vertiefung 31 aufweist, in der das Lumineszenzkonversionselement 6 enthalten ist.

Wie beim siebten Ausführungsbeispiel verläuft damit die Ausbreitungsrichtung der Primärstrahlung 5 zunächst nicht in Richtung zu dem Lumineszenzkonversionselement 6 hin, sondern versetzt zu diesem. Jeder Primärstrahlungsquelle 1 ist jedoch ein Segment 81 oder 82 des wellenlängenselektiven Auskoppelspiegels 8 zugeordnet, der - ähnlich wie beim vorhergehenden Ausführungsbeispiel - zugleich ein optisches Element 10 darstellt, welches die Primärstrahlung 5 zur Lichtauskoppelfläche 601 des Lumineszenzkonversionselements 6 hin umlenkt. Die Segmente 81, 82 des Auskoppelspiegels 8 sind vorliegend in ein zumindest teilweise lichtdurchlässiges, vorzugsweise transparentes Positionierungselement 10B eingebettet. Alternativ können sie auch an Außenflächen des Positionierungselements 10B ausgebildet, angeformt oder befestigt sein. Mittels des Positionierungselements 10B ist der wellenlängenselektive Auskoppelspiegel 8 auf einfache Weise zu dem Lumineszenkonversionselement 6 ausgerichtet. Vorliegend hat das Postionierungselement 10B auch eine mechanische Schutzfunktion für die Lichtauskoppelfläche 601.

Die beiden Segmente 81, 82 des Auskoppelspiegels 8 stoßen an einer gemeinsamen Kante zusammen, so dass der Auskoppelspiegel 8 einen V-förmigen Querschnitt hat. Die Spitze des "V" und damit die gemeinsame Kante der Segmente 81, 82 ist dabei der Lichtauskoppelfläche 601 zugewandt. Die Segmente 81, 82 des optischen Elements 10 sind bei dem neunten Ausführungsbeispiel ebene Flächen und schließen mit der Lichtauskoppelfläche 601 einen Winkel γ ein, der vorliegend einen Wert von 45° hat.

Auf das optische Element 10 mit dem wellenlängenselektiven Auskoppelspiegel 8 ist beispielsweise ein Strahlformungselement 9 aufgebracht, das zur Formung der von den Segmenten 81, 82 des Auskoppelspiegels 8 durchgelassenen Sekundärstrahlung 15 vorgesehen ist. Das Strahlformungselement kann bei einer Weiterbildung mit dem optischen Element kombiniert ausgebildet sein.

Bei einer Variante dieser Ausgestaltung weist der Auskoppelspiegel 8 vier Segmente 81, 82 auf, welche beispielsweise die Seitenflächen einer Pyramide mit einer quadratischen oder rechteckigen Grundfläche darstellen. Die Spitze der Pyramide 81, 82 ist vorzugsweise der Lichtauskoppelfläche 601 zugewandt, ihre Mittelachse steht bevorzugt senkrecht auf der Lichtauskoppelfläche 601. Bei dieser Variante weist die Halbeiterlichtquelle beispielsweise vier Primärstrahlungsquellen 1 auf, die jeweils eines der Segmente beleuchten.

## Patentansprüche

1. Halbleiterlichtquelle mit einer Primärstrahlungsquelle (1), wobei die Primärstrahlungsquelle (1) einen Halbleiterchip umfasst, der im Betrieb der Halbleiterlichtquelle elektromagnetische Primärstrahlung (5) emittiert, und mit einem Lumineszenzkonversionsmodul (2), in welches zumindest ein Teil der Primärstrahlung (5) eingekoppelt wird, wobei
- das Lumineszenzkonversionsmodul (2), ein Lumineszenzkonversionselement (6) enthält, welches zumindest einen Teil der eingekoppelten Primärstrahlung (5) mittels mindestens eines Leuchtstoffs in eine Sekundärstrahlung (15) wellenlängenkonvertiert,
- das Lumineszenzkonversionsmodul (2) von der Primärstrahlungsquelle (1) beabstandet an einem Kühlkörper (3) angeordnet ist,
- das Lumineszenzkonversionselement (6) die Form einer im Wesentlichen ebenen Schicht oder einer Platte hat, deren Oberfläche eine erste Hauptfläche (601), welche eine Lichtauskoppelfläche darstellt, eine zweite Hauptfläche (602), die der ersten Hauptfläche gegenüberliegt und dem Kühlkörper (3) zugewandt ist, und mindestens eine Seitenfläche (603) aufweist,
- im Betrieb die Primärstrahlung (5) durch die erste Hauptfläche (601) oder durch die Seitenfläche (603) in das Lumineszenzkonversionselement (6) eingekoppelt wird,
- das Lumineszenzkonversionsmodul (2) eine Reflektorschicht (7, 71, 72) aufweist,
- die Reflektorschicht (7, 71, 72) die durch das Lumineszenzkonversionselement (6) tretende, von diesem nicht absorbierte Primärstrahlung (5) in das Lumineszenzkonversionselement (6) zurück reflektiert und die Sekundärstrahlung (15) in Richtung der Lichtauskoppelfläche (601) des Lumineszenzkonversionsmoduls (2) reflektiert,
- ein erster Teilbereich (71) der Reflektorschicht (7, 71, 72) zwischen dem Lumineszenzkonversionselement (6) und dem Kühlkörper (3) angeordnet ist,
- ein zweiter Teilbereich (72) der Reflektorschicht (7, 71, 72) die Seitenfläche (603) des Lumineszenzkonversionselements (6) zumindest stellenweise bedeckt.

2. Halbleiterlichtquelle gemäß Anspruch 1, bei der die Primärstrahlungsquelle (1) an dem gleichen Kühlkörper (3) angeordnet ist wie das Lumineszenzkonversionsmodul (2).

3. Halbleiterlichtquelle gemäß Anspruch 1 oder 2, bei der der zweite Teilbereich (72) der Reflektorschicht (7, 71, 72) die mindestens eine Seitenfläche (603) vollständig bedeckt.

4. Halbleiterlichtquelle gemäß einem der vorhergehenden Ansprüche, bei der der erste Teilbereich (71) der Reflektorschicht (7, 71, 72) die zweite Hauptfläche (602) wenigstens stellenweise bedeckt.

5. Halbleiterlichtquelle gemäß einem der vorhergehenden Ansprüche, bei der Primärstrahlung (5) der Primärstrahlungsquelle (1) durch die Seitenfläche (603) in das Lumineszenzkonversionselement (6) eingekoppelt wird und bei der die Einkopplung durch einen wellenlängenselektiven Einkoppelspiegel (12) hindurch erfolgt, welcher einen großen Transmissionskoeffizienten für die Primärstrahlung (5) und einen großen Reflexionskoeffizienten für die Sekundärstrahlung (15) hat.

6. Halbleiterlichtquelle gemäß einem der vorhergehenden Ansprüche, bei der die Auskopplung der Sekundärstrahlung (15) aus dem Lumineszenzkonversionsmodul (2) durch einen wellenlängenselektiven Auskoppelspiegel (8) hindurch erfolgt, weleher einen großen Reflexionskoeffizienten zumindest für einen Teil der Primärstrahlung (5) und einen großen Transmissionskoeffizienten für die Sekundärstrahlung (15) hat.

7. Halbleiterlichtquelle gemäß einem der vorhergehenden Ansprüche, bei der das Lumineszenzkonversionsmodul (2) mindestens ein Kühlelement (13) aufweist, das in das Lumineszenzkonversionselement (6) hineinragt oder durch das Lumineszenzkonversionselement (6) hindurch ragt und thermisch leitend mit dem Kühlkörper (3) verbunden ist.

8. Halbleiterlichtquelle gemäß einem der vorhergehenden Ansprüche, bei der Primärstrahlung (5) mittels eines optischen Elements (10) in das Lumineszenzkonversionsmodul (2) eingekoppelt wird.

9. Halbleiterlichtquelle gemäß Anspruch 8, bei der das optische Element (10) einen wellenlängenselektiven Auskoppelspiegel (8) aufweist, welcher einen großen Reflexionskoeffizienten zumindest für einen Teil der Primärstrahlung (5) und einen großen Transmissionskoeffizienten für die Sekundärstrahlung (15) hat und die Auskopplung der Sekundärstrahlung (15) aus dem Lumineszenzkonversionsmodul (2) durch den wellenlängenselektiven Auskoppelspiegel (8) hindurch erfolgt.

10. Halbleiterlichtquelle gemäß einem der vorhergehenden Ansprüche, bei der der Kühlkörper (3) das Lumineszenzkonversionselement (6) umgreift.

11. Halbleiterlichtquelle gemäß Anspruch 10, bei der das Lumineszenzkonversionselement (6) zumindest teilweise in einer Vertiefung (31) des Kühlkörpers (3) angeordnet ist und zumindest ein Teilbereich der Oberfläche der Vertiefung (31) die Reflektorschicht (7, 71, 72) oder einen Teil der Reflektorschicht (7, 71, 72) bildet.

## Claims

1. A semiconductor light source having a primary radiation source (1), the primary radiation source (1) comprising a semiconductor chip, which emits electromagnetic primary radiation (5) during operation of the semiconductor light source, and comprising a luminescence conversion module (2) into which at least a part of the primary radiation (5) is coupled, wherein
- the luminescence conversion module (2) contains a luminescence conversion element (6) which converts at least part of the coupled primary radiation (5) into a secondary radiation (15) by means of at least one phosphor,
- the luminescence conversion module (2) is arranged at a distance from the primary radiation source (1) on a heat sink (3),
- the luminescence conversion element (6) is in the form of a substantially planar layer or plate, the surface of which has a first major surface (601) representing a light-outcoupling surface, a second major surface (602) opposite the first major surface and facing the heat sink (3), and at least one side surface (603),
- during operation, the primary radiation (5) is coupled into the luminescence conversion element (6) through the first major surface (601) or through the side surface (603),
- the luminescence conversion module (2) comprises a reflector layer (7, 71, 72),
- the reflector layer (7, 71, 72) reflects the primary radiation (5), which passes through the luminescence conversion element (6) and is not absorbed therefrom, back into the luminescence conversion element (6) and reflects the secondary radiation (15) in the direction of the light-outcoupling surface (601) of the luminescence conversion module (2),
- a first partial region (71) of the reflector layer (7, 71, 72) is arranged between the luminescence conversion element (6) and the heat sink (3),
- a second partial region (72) of the reflector layer (7, 71, 72) at least partially covers the side surface (603) of the luminescence conversion element (6).

2. The semiconductor light source according to claim 1, wherein the primary radiation source (1) is disposed on the same heat sink (3) as the luminescence conversion module (2).

3. The semiconductor light source according to claim 1 or 2, wherein the second partial region (72) of the reflector layer (7, 71, 72) completely covers the at least one side surface (603) .

4. The semiconductor light source according to one of the preceding claims, wherein the first partial region (71) of the reflective layer (7, 71, 72) at least partially covers the second major surface (602).

5. The semiconductor light source according to one of the preceding claims, in which primary radiation (5) of the primary radiation source (1) is coupled into the luminescence conversion element (6) through the side surface (603) and in which the coupling is effected through a wavelength-selective coupling mirror (12) having a large transmission coefficient for the primary radiation (5) and a large reflection coefficient for the secondary radiation (15).

6. The semiconductor light source according to one of the preceding claims, in which the outcoupling of the secondary radiation (15) from the luminescence conversion module (2) is effected through a wavelength-selective outcoupling mirror (8) having a large reflection coefficient at least for a portion of the primary radiation (5) and a large transmission coefficient for the secondary radiation (15).

7. The semiconductor light source according to one of the preceding claims, in which the luminescence conversion module (2) has at least one cooling element (13) which projects into the luminescence conversion element (6) or projects through the luminescence conversion element (6) and is thermally conductively connected to the heat sink (3).

8. The semiconductor light source according to one of the preceding claims, in which primary radiation (5) is coupled into the luminescence conversion module (2) by means of an optical element (10).

9. The semiconductor light source according to claim 8, in which the optical element (10) comprises a wavelength-selective outcoupling mirror (8) having a large reflection coefficient for at least a part of the primary radiation (5) and a large transmission coefficient for the secondary radiation (15), and the secondary radiation (15) is coupled out of the luminescence conversion module (2) through the wavelength-selective outcoupling mirror (8).

10. The semiconductor light source according to one of the preceding claims, in which the heat sink (3) embraces the luminescence conversion element (6).

11. The semiconductor light source according to claim 10, in which the luminescence conversion element (6) is arranged at least partially in a depression (31) of the heat sink (3) and at least a partial region of the surface of the depression (31) forms the reflector layer (7, 71, 72) or a part of the reflector layer (7, 71, 72).

## Revendications

1. Source lumineuse à semi-conducteur dotée d'une source de rayonnement primaire (1), ladite source de rayonnement primaire (1) comprenant une puce semi-conductrice qui émet, lorsque la source lumineuse à semi-conducteur est en marche, un rayonnement primaire électromagnétique (5), et dotée d'un module à conversion de luminescence (2) dans lequel est introduite au moins une partie du rayonnement primaire (5),
- le module à conversion de luminescence (2) comprenant un élément à conversion de luminescence (6) qui procède au moyen d'au moins une substance luminescente à la conversion par longueur d'onde d'au moins une partie du rayonnement primaire (5) introduit en un rayonnement secondaire (15),
- le module à conversion de luminescence (2) étant agencé sur un refroidisseur (3) à distance de la source de rayonnement primaire (1),
- l'élément à conversion de luminescence (6) ayant la forme d'une couche sensiblement plane ou d'une plaque dont la surface présente une première surface principale (601) qui représente une surface de découplage de la lumière, une deuxième surface principale (602) qui est à l'opposé de la première surface principale et tournée vers le refroidisseur (3), et au moins une surface latérale (603),
- en marche, le rayonnement primaire (5) étant introduit par la première surface principale (601) ou par la surface latérale (603) dans l'élément à conversion de luminescence (6),
- le module à conversion de luminescence (2) présentant une couche réfléchissante (7, 71, 72),
- la couche réfléchissante (7, 71, 72) réfléchissant en retour dans l'élément à conversion de luminescence (6) le rayonnement primaire (5) pénétrant dans l'élément à conversion de luminescence (6) et non absorbé par ce dernier et réfléchissant le rayonnement secondaire (15) vers la surface de découplage de la lumière (601) du module à conversion de luminescence (2),
- une première zone (71) de la couche réfléchissante (7, 71, 72) étant agencée entre l'élément à conversion de luminescence (6) et le refroidisseur (3),
- une deuxième zone (72) de la couche réfléchissante (7, 71, 72) recouvrant au moins par endroit la surface latérale (603) de l'élément à conversion de luminescence (6)

2. Source lumineuse à semi-conducteur selon la revendication 1, dans laquelle la source de rayonnement primaire (1) est agencée au même refroidisseur (3) que le module à conversion de luminescence (2).

3. Source lumineuse à semi-conducteur selon la revendication 1 ou 2, dans laquelle la deuxième zone (72) de la couche réfléchissante (7, 71, 72) recouvre intégralement l'au moins une surface latérale (603).

4. Source lumineuse à semi-conducteur selon l'une quelconque des revendications précédentes, dans laquelle la première zone (71) de la couche réfléchissante (7, 71, 72) recouvre au moins par endroit la deuxième surface principale (602).

5. Source lumineuse à semi-conducteur selon l'une quelconque des revendications précédentes, dans laquelle un rayonnement primaire (5) de la source de rayonnement primaire (1) est introduit dans l'élément à conversion de luminescence (6) par la surface latérale (603) et dans laquelle cette introduction s'effectue au travers d'un miroir d'entrée (12) à sélection par longueur d'onde qui a un coefficient de transmission élevé pour le rayonnement primaire (5) et un coefficient de réflexion élevé pour le rayonnement secondaire (15).

6. Source lumineuse à semi-conducteur selon l'une quelconque des revendications précédentes, dans laquelle le découplage du rayonnement secondaire (15) sortant du module à conversion de luminescence (2) s'effectue au travers d'un miroir de sortie (8) à sélection par longueur d'onde qui a un coefficient de réflexion élevé au moins pour une partie du rayonnement primaire (5) et un coefficient de transmission élevé pour le rayonnement secondaire (15).

7. Source lumineuse à semi-conducteur selon l'une quelconque des revendications précédentes, dans laquelle le module à conversion de luminescence (2) présente au moins un élément refroidisseur (13) qui rentre en saillie dans l'élément à conversion de luminescence (6) ou traverse l'élément à conversion de luminescence (6) et est relié de manière thermoconductrice au refroidisseur (3).

8. Source lumineuse à semi-conducteur selon l'une quelconque des revendications précédentes, dans laquelle un rayonnement primaire (5) est introduit dans le module à conversion de luminescence (2) au moyen d'un élément optique (10).

9. Source lumineuse à semi-conducteur selon la revendication 8, dans laquelle l'élément optique (10) présente un miroir de découplage (8) à sélection par longueur d'onde qui a un coefficient de réflexion élevé au moins pour une partie du rayonnement primaire (5) et un coefficient de transmission élevé pour le rayonnement secondaire (15), et dans laquelle le découplage du rayonnement secondaire (15) sortant du module à conversion de luminescence (2) s'effectue au travers du miroir de découplage (8) à sélection par longueur d'onde.

10. Source lumineuse à semi-conducteur selon l'une quelconque des revendications précédentes, dans laquelle le refroidisseur (3) entoure l'élément à conversion de luminescence (6).

11. Source lumineuse à semi-conducteur selon la revendication 10, dans laquelle l'élément à conversion de luminescence (6) est agencé au moins partiellement dans un renfoncement (31) du refroidisseur (3) et au moins une zone de la surface dudit renfoncement (31) forme la couche réfléchissante (7, 71, 72) ou une partie de la couche réfléchissante (7, 71, 72).
